Europäisches Patentamt

**(19)** European Patent Office

Office européen des brevets

**(11)** Publication number : **0 455 079 B1**

**(12)** # EUROPEAN PATENT SPECIFICATION

**(45)** Date of publication of patent specification :
22.03.95 Bulletin 95/12

**(51)** Int. Cl.⁶ : **H03K 19/0175,** H03K 19/094,
H03K 19/013

**(21)** Application number : **91106387.3**

**(22)** Date of filing : **20.04.91**

**(54) CMOS to ECL level converter for digital signals.**

**(30)** Priority : **30.04.90 ES 9001241**

**(43)** Date of publication of application :
**06.11.91 Bulletin 91/45**

**(45)** Publication of the grant of the patent :
**22.03.95 Bulletin 95/12**

**(84)** Designated Contracting States :
**BE DE DK FR GB IT NL**

**(56)** References cited :
EP-A- 0 305 098
WO-A-87/03435
US-A- 4 890 019
PATENT ABSTRACTS OF JAPAN vol. 14, no.
65 (E-884)(4008), 6 February 1990; JP A 1 284
114 (NIPPON TELEGRAPH & TELEPHONE
CORP.) 15.11.1989

**(73)** Proprietor : **ALCATEL STANDARD
ELECTRICA, S.A.
Ramirez de Prado, 5
ES-28045 Madrid (ES)**

**(72)** Inventor : **Merino Gonzalez, Jose Luis
c/ Alcalde Sainz de Baranda, 65-5q C
E-28009 Madrid (ES)**
Inventor : **Ortiz Saenz, Fernando
c/ Agustina de Arag n, 10-2q 10
E-28006 Madrid (ES)**

**(74)** Representative : **Pohl, Herbert, Dipl.-Ing et al
Alcatel SEL AG
Patent- und Lizenzwesen
Postfach 30 09 29
D-70449 Stuttgart (DE)**

# Description

## OBJECT OF THE INVENTION

This invention, as stated in the title of this document, refers to a complementary metal oxide semiconductor (CMOS) logic to emitter coupled logic (ECL) level converter of digital signals. Its purpose is to achieve a minimum delay in the signal conversion, without any need for additional power supply or increasing the number of outputs.

The invention in question is applicable to high frequency integrated circuits having high capacitive loads.

## BACKGROUND TO THE INVENTION

At present CMOS to ECL digital signal converters are known, based on different technical solutions which, on one hand depend on available technology and, on the other, on known converter design practice.

Firtsly, use was made of the current mirror technique, however this had the drawback of having a very high delay time in the conversion of the signals; its application was therefore not recommended in circuits with a high operating frequency, for example more than 155 Mbit/s, as the minimum delay times achievable (2 to 3 ns) are too high for the working frequency range mentioned.

Other types of frequency converters employed conventionally, are those known as the "open collector output converters", such as those described in the USA Patent No. 4.656.375, by the NCR Corporation, in which the technique mentioned is used in order to obtain a "temperature-compensated CMOS to ECL converter". This type of converter has the serious drawback of requiring an additional power supply, as well as a series of additional, external components in the output stage.

Presently, differential converters are also known, as described in the USA Patent No. 4.645,951, by HITACHI and which makes reference to "an integrated circuit which has an internal CMOS logic block and an output circuit providing ECL logic levels". This type of converter has the disadvantage of having an unoptimised number of inputs and/or outputs, which results in a problem to overcome when the total number of pins of an integrated circuit is limited, as is the case in the application being considered.

## TECHNICAL PROBLEM TO BE OVERCOME

Consequently the technical problem to be overcome consists in obtaining a CMOS to ECL level converter of digital signals with a minimum delay time without using additional power supply and without increasing the number of outputs to the circuit, for integrated circuits working at high frequency and with high capacitive loads.

## CHARACTERISATION OF THE INVENTION

In order to overcome the disadvantages mentioned above, the invention consist of a complementary metal-oxide-semiconductor (CMOS) logic to emitter-coupled logic (ECL) level converter of digital signals, which comprises a P-MOS transistor whose gate is connected to the CMOS level signal input, the source of which is connected to the highest voltage point of the circuit, to the collector of a first bipolar transistor, and to one end of a resistor, and whose drain is connected to the drain of a first N-MOS transistor and to the emitter of a second bipolar transistor.

The gate of the first N-MOS transistor is connected to the gate of a second N-MOS transistor and to the bias voltage needed to set the current of the two N-MOS transistors; and the source of the first N-MOS transistor is connected to the source of the second N-MOS transistor and to the point with the lowest voltage of the converter.

The base of the second bipolar transistor is connected to a point where the voltage is that necessary for switching the second bipolar transistor, and the collector of the second bipolar transistor is connected to the base of the first bipolar transistor and to the resistor.

The emitter of the first bipolar transistor is connected to the drain of the second N-MOS transistor, and the common point constitutes the ECL level output of the converter.

The P-MOS transistor constitutes a first current source which is cut off when a logical C-MOS "1" is received at its input gate, at which point it ceases to work as a current source. The first N-MOS transistor, for its part, constitutes a second current source required to ensure the controlled operation of the converter input stage.

The first bipolar transistor and the second N-MOS transistor form a buffer storage device which constitutes a third current source and which forms the low impedance output of the ECL signal from the converter.

In this way, through the structure of the invention, a minimum delay is achieved in the conversion of the input signal levels using a reduced number of components, meaning that the integration area occupied is smaller. In addition, the total converter current consumption depends on the value of the converter's capacitive load, and falls when the load falls.

Another important characteristic of the invention to note is the fact that both a very high input impedance and a very low output impedance are obtained simultaneously.

It has to be stated that, by means of the invention, the minimum delay mentioned above is achieved, with no need for additional power supply nor increase in the number of circuit outputs, for integrated circuits working at high frequency with high capactive loads.

Below, to facilitate a better understanding of this specification and forming an integral part thereof, a series of figures are attached by way of illustration, without limiting the purpose of the invention.

## BRIEF DESCRIPTION OF THE FIGURES

Figure 1 shows a schematic of the CMOS to ECL level converter of digital signals in accordance with the invention.

Figure 2 shows a timing diagram of the input and output signals, as well as of the minimum delay achieved in level conversion.

## DESCRIPTION OF AN IMPLEMENTATION OF THE INVENTION

A description is given below of the invention based on the figures explained above.

The invention, therefore, consists of a complementary metal-oxide-semiconductor (CMOS) logic to emitter-coupled logic (ECL) level converter of digital signals, which is applicable to integrated circuits working at high frequency and having a high capacitive load, and which incorporates a P-MOS transistor T1, the gate of which is connected to the input 1 of the CMOS level signal. Moreover, the transistor T1 is also connected to a bipolar transistor T3, the collector of which is connected to the voltage Vdd through the resistor R1, the base of this transistor T3 being connected to a reference voltage $Vb_1$.

The collector of the bipolar transistor T3 is connected to the base of the bipolar transistor T4 which, in turn, is connected to the N-MOS transistor T5, such that the bipolar transistor T4 lowers the voltage at the output by an amount equal to the voltage drop across its base-to-emitter junction, while the N-MOS transistor T5 constitutes a current source that ensures a low impedance output and avoids the need to use an additional power supply. The buffer storage device formed by the transistors T4 and T5 permits charging and discharging of high capacitive loads at high frequencies with a minimum delay R.

The gate of the N-MOS transistor T5 is connected to the gate of the N-MOS transistor T2, which similarly constitutes a new current source.

In this way, by means of the converter described in the invention, when a CMOS logical "0" appears at the gate of the P-MOS transistor T1 (Vcmos = "0"), the transistor T1 behaves as a current source. In this situation, the N-MOS transistor T2 also behaves as a current source controlled by the value of the bias voltage ($Vb_2$) present at point 6, the two current sources operating as a voltage divider in such a way that the voltage at point 8 (V1) is set at a value $\geq Vb_1$.

In this situation the bipolar transistor T3 switches to the cut-off state, making the voltage Vec1 at the output of the bipolar transistor T4 equal to:

$$Vec1 = Vdd - (IbT4 \times R1) - VbeT4.$$

IbT4 corresponds to the current flowing through the base of the bipolar transistor T4.

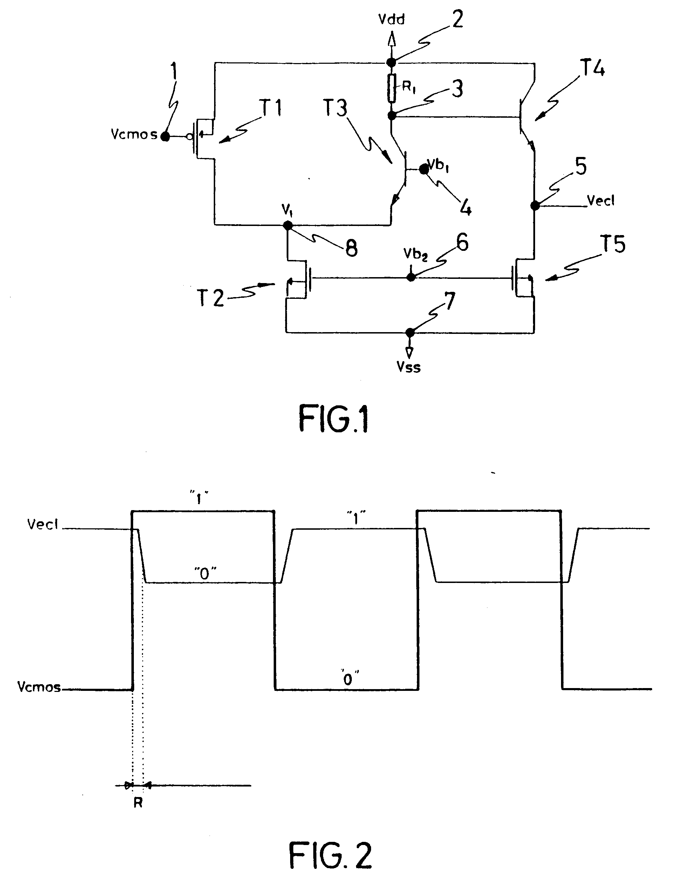

This output level corresponds to an ECL logical "1" (figure 2), this level appearing with a certain delay R with respect to the input level Vcmos, a delay which however is minimum, as has been commented earlier.

If, on the other hand, a CMOS logical "1" (Vcmos = "1") appears at the gate of the transistor T1, the transistor T1 does not conduct which means that the voltage $V_1 = Vb1 - VbeT3$. In this situation the transistor T3 is conducting, the current being set by the current source formed by the N-MOS transistor T2.

Consequently the output voltage will be:

$$Vec1 = Vdd - ((IT2 + IbT4) \times R_1) - VbeT4.$$

IT2 corresponds to the current flowing in this situation through the bipolar transistor T3 and through the current source T2.

The output level previously indicated corresponds to an ECL logical "0" (figure 2).

Vdd represents the highest voltage level of the converter, which corresponds to the CMOS logical "1" input level, while Vss represents the lowest voltage level of the converter, corresponding to the CMOS logical "0" input level.

In this way, a converter is obtained with a reduced number of components and thereby requiring a very small area of integration. Another advantage is that the total current consumed by the circuit depends on the circuit's capacitive load, and falls when the load gets smaller.

## Claims

1. COMPLEMENTARY METAL-OXIDE-SEMICONDUCTOR (CMOS) LOGIC TO EMITTER-COUPLED LOGIC (ECL) LEVEL CONVERTER OF DIGITAL SIGNALS, applicable to integrated circuits working at high frequency and having high capacitive load, and which has the object of achieving a minimum delay in the conversion without need for additional power supply and without increasing the number of outputs; comprising

   - a P-MOS transistor (T1) whose gate is connected to the CMOS level signal input (1), the source of which is connected to the highest voltage point (2) of the circuit, to the collector of a first bipolar transistor (T4), and to one end of a resistor (R1); and whose drain is connected to the point (8) common to the drain of a first N-MOS transistor (T2) and to the emitter of a second bipolar transistor (T3), whereby

- the gate of the first N-MOS transistor (T2) is connected to the gate of a second N-MOS transistor (T5) and to the common point (6) where the bias voltage $(V_{b2})$ necessary to set the current in the two N-MOS transistors (T5 and T2) is present; and the source of the first N-MOS transistor (T2) is connected to the point (7) with the lowest voltage of the converter, and to the source of the second N-MOS transistor (T5),
- the base of the second bipolar transistor (T3) is connected to a point (4) where the voltage $(V_{b1})$ is that necessary for switching the second bipolar transistor (T3); and the collector of the second bipolar transistor is connected to point (3) common to the base of the first bipolar transistor (T4) and to the other end of the resistor (R1), and
- the emitter of the first bipolar transistor (T4) is connected to the drain of the second N-MOS transistor (T5), and the common point (5) which constitutes the ECL level output of the converter.

2. COMPLEMENTARY METAL-OXIDE-SEMICONDUCTOR (CMOS) LOGIC TO EMITTER-COUPLED LOGIC (ECL) LEVEL CONVERTER OF DIGITAL SIGNALS according to claim 1, whereby the P-MOS transistor (T1) constitutes a first current source which is cut off when a logical CMOS "1" is received at its input gate, at which point it ceases to work as a current source.

3. COMPLEMENTARY METAL-OXIDE-SEMICONDUCTOR (CMOS) LOGIC TO EMITTER-COUPLED LOGIC (ECL) LEVEL CONVERTER OF DIGITAL SIGNALS according to claim 1, whereby the first N-MOS transistor (T2), constitutes a second current source required to ensure the controlled operation of the converter input stage.

4. COMPLEMENTARY METAL-OXIDE-SEMICONDUCTOR (CMOS) LOGIC TO EMITTER-COUPLED LOGIC (ECL) LEVEL CONVERTER OF DIGITAL SIGNALS according to claim 1, whereby the first bipolar transistor (T4) and the second N-MOS transistor (T5) form a buffer storage device which constitutes a third current source and which forms the low impedance output of the ECL signal from the converter.

**Patentansprüche**

1. Pegelwandler für digitale Signale aus einer Komplementär-Metalloxidhalbleiter(CMOS)-Logik in eine emittergekoppelte Logik (ECL) für eine bei hohen Frequenzen und hoher kapazitiver Belastung arbeitenden integrierten Schaltungen, in welchem bei der Umsetzung eine geringe Verzögerung auftritt und welcher keine zusätzliche Energieversorgung und keine erhöhte Anzahl von Ausgängen benötigt. Sie enthält:

a) einen P-MOS-Transistor (T1), dessen Gate mit dem CMOS-Pegelsignaleingang (1) verbunden ist. Die Source des P-MOS-Transistors (T1) ist mit der höchsten Spannung (2) der Schaltung, dem Kollektor des ersten bipolaren Transistors (T4) und mit einem Ende eines Widerstandes (R1) verbunden. Die Drain des P-MOS-Transistors (T1) ist mit dem Verbindungspunkt (8) zwischen der Drain des ersten N-MOS-Transistors (T2) und dem Emitter des zweiten bipolaren Transistors (T3) verbunden;

b) das Gate des ersten N-MOS-Transistors (T2) ist mit dem Gate eines zweiten N-MOS-Transistors (T5) und dem Verbindungspunkt (6) verbunden, an welchem die Vorspannung $(V_{b2})$, welche zur Einstellung des Stromes in den zwei N-MOS-Transistoren (T2, T5) benötigt wird, anliegt. Die Source des ersten N-MOS-Transistors (T2) ist mit dem die niedrigste Spannung des Wandlers aufweisenden Punkt (7) und der Source des zweiten N-MOS-Transistors (T5) verbunden;

c) die Basis des zweiten bipolaren Transistors (T3) ist mit einem Verbindungspunkt (4) verbunden, an dem die Spannung $(V_{b1})$ vorhanden ist, welche zum Schalten des zweiten bipolaren Transistors (T3) ausreicht. Der Kollektor des zweiten bipolaren Transistors ist mit dem Verbindungspunkt (3) verbunden, an dem die Basis des ersten bipolaren Transistors (T4) und das andere Ende des Widerstandes (R1) liegen;

d) der Emitter des ersten bipolaren Transistors (T4) ist mit der Drain des zweiten N-MOS-Transistors (T5) verbunden, deren Verbindungspunkt (5) ist der ECL-Pegelausgang des Wandlers.

2. Pegelwandler für digitale Signale nach Anspruch 1, dadurch gekennzeichnet, daß der P-MOS-Transistor (T1) eine erste Stromquelle darstellt, welche gesperrt ist und nicht als Stromquelle arbeitet, wenn eine logische CMOS "1" an seinem Gateeingang vorhanden ist.

3. Pegelwandler für digitale Signale nach Anspruch 1, dadurch gekennzeichnet, daß der erste N-MOS-Transistor (T2) eine zweite Stromquelle darstellt, welche den gesteuerten Betrieb der Wandlereingangsstufe sicherstellt.

**4.** Pegelwandler für digitale Signale nach Anspruch 1, dadurch gekennzeichnet, daß der erste bipolare Transistor (T4) und der zweite N-MOS-Transistor (T5) einen Zwischenspeicher bilden, welcher eine dritte Stromquelle darstellt und den niederohmigen Ausgang des Wandlers für das ECL-Signal bildet.

**Revendications**

**1.** Convertisseur du niveau de la logique à transistors métal-oxyde-semiconducteur (CMOS) complémentaires en le niveau de la logique à couplage par les émetteurs, pour les signaux numériques, applicable à des circuits intégrés travaillant à haute fréquence et présentant une charge capacitive élevée, et dont l'objet est d'obtenir un retard minimal dans la conversion sans nécessiter d'alimentation puissance supplémentaire et sans accroître le nombre de sorties; comportant :
- un transistor MOS de type P (T1) dont la grille est reliée à l'entrée (1) du signal de niveau CMOS, dont la source est reliée au point de tension la plus élevée (2) du circuit, au collecteur d'un premier transistor bipolaire (T4), et à la première extrémité d'une résistance (R1); et dont le drain est relié au point (8) commun au drain d'un premier transistor MOS de type N (T2) et à l'émetteur d'un second transistor bipolaire (T3), convertisseur dans lequel
- la grille du premier transistor MOS de type N (T2) est reliée à la grille d'un second transistor de type N (T1) et au point commun (6) où est présente la tension de polarisation ($vb_2$) nécessaire pour piloter le courant passant dans les deux transistors MOS de type N (T5 et T2), et la source du premier transistor MOS de type N (T2) est reliée au point (7) présentant la tension la plus basse du convertisseur et à la source du second transistor MOS de type N (T5),
- la base du second transistor bipolaire (T3) est reliée à un point (4) où la tension ($vb_1$) est celle nécessaire pour le fonctionnement du second transistor bipolaire (T3); et le collecteur du second transistor bipolaire est relié au point (3) commun à la base du premier transistor bipolaire (T4) et à l'autre extrémité de la résistance (R1), et
- l'émetteur du premier transistor bipolaire (T4) est relié au drain du second transistor MOS de type N (T5) et au point commun (5) qui constitue la sortie de niveau ECL du convertisseur.

**2.** Convertisseur du niveau de la logique à transistors métal-oxyde-semiconducteur (CMOS) complémentaires en le niveau de la logique à couplage par les émetteurs, pour les signaux numériques, selon la revendication 1, dans lequel le transistor MOS de type P (T1) constitue une première source de courant qui est coupée lorsqu'un "1" CMOS logique est reçu à sa grille d'entrée, instant auquel il cesse de travailler comme source de courant .

**3.** Convertisseur du niveau de la logique à transistors métal-oxyde-semiconducteur (CMOS) complémentaires en le niveau de la logique à couplage par les émetteurs, pour les signaux numériques, selon la revendication 1, dans lequel le premier transistor MOS de type N (T2) constitue une seconde source de courant nécessaire pour assurer le fonctionnement commandé de l'étage d'entrée du convertisseur.

**4.** Convertisseur du niveau de la logique à transistors métal-oxyde-semiconducteur (CMOS) complémentaires en le niveau de la logique à couplage par les émetteurs, pour les signaux numériques, selon la revendication 1, dans lequel le premier transistor bipolaire (T4) et le second transistor MOS de type N (T5) forment un composant de mémorisation tampon qui constitue une troisième source de courant et qui forme la sortie de faible impédance du signal ECL du convertisseur.

FIG.1

FIG. 2